# EUROPÄISCHE PATENTSCHRIFT

(11) **EP 0 691 737 B1**
(45) Veröffentlichungstag und Bekanntmachung des Hinweises auf die Patenterteilung: **18.04.2001**
(21) Anmeldenummer: 95110105.4
(22) Anmeldetag: 28.06.1995
(51) Int. Cl.: H03H 1/00

(54) **Koaxiales Durchführungsfilter**
Coaxial feedthrough filter
Filtre de traversée coaxial

(30) Priorität: 06.07.1994 DE 4423734
(43) Veröffentlichungstag der Anmeldung: 10.01.1996
(73) Patentinhaber: EPCOS AG, 81541 München (DE)
(72) Erfinder: Gött, Achim, Dipl.-Ing., D-89520 Heidenheim (DE); Schmittmann, Helmut, Dipl.-Ing., D-89537 Giengen (DE)
(74) Vertreter: Epping, Wilhelm, Dipl.-Ing.

(56) Entgegenhaltungen:
- DE-A- 4 011 294
- DE-C- 930 331
- US-A- 3 638 147

## Beschreibung

Die Erfindung betrifft ein koaxiales Durchführungsfilter in π-Schaltung mit zwei kapazitiven Quergliedern und einem ferromagnetischen Längsglied, bei dem die kapazitiven Glieder aus Wickelkondensatoren bestehen, die zusammen mit dem ferromagnetischen Glied auf einem Durchführungsleiter angeordnet sind.

Derartige Durchführungsfilter werden zur breitbandigen Entstörung von Starkstrombetriebsmitteln benötigt. Die in π-Schaltung aufgebauten Filter bestehen aus zwei gleichen kapazitiven Quergliedern und einem ferromagnetischen Längsglied. Zur Erzielung ausreichend hoher Dämpfungswerte müssen die einzelnen Bauteile konzentrisch angeordnet werden.

Bisher werden die kapazitiven Querglieder in Form zweier einzelner Kondensatorwickel ausgeführt, deren Wickelstirnseiten je nach Aufbau durch mindestens drei metallische Lötscheiben mit dem Durchführungsleiter und dem Gehäuse verbunden sind. Zur Realisierung der π-Schaltung muß zwischen den Kontaktstellen der Wickelstirnseiten das ferromagnetische Längsglied eingebaut werden. Ferner wird jeweils eine der Stirnseiten der Wickelkapazitäten mit dem Gehäuse verbunden.

Durch den geschilderten Aufbau werden leitungsgebundene Störungen also über das Gehäuse und die Schirmwand der zu entstörenden Anlage abgeleitet.

Aus der DE-A-930 331 ist eine Einrichtung zur Entstörung bekannt, die aus zwei konzentrisch übereinander angeordneten Kondensatoren besteht, die auf einem Durchführungsleiter angeordnet sind.

Weiterhin ist aus der DE-A1-40 11 294 ein laminiertes LC-Filter in π-Schaltung bekannt, das keinen Durchführungsleiter aufweist.

Aufgabe der vorliegenden Erfindung ist es, ein koaxiales Durchführungsfilter der eingangs genannten Art derart zu verbessern, daß die geschilderten Schwierigkeiten behoben werden.

Diese Aufgabe wird erfindungsgemäß durch ein Durchführungsfilter nach Anspruch 1 gelöst. Die kapazitiven Querglieder sind in Form eines einzigen Kondensatorwickels ausgeführt, dessen Teilkapazitäten übereinander auf ein metallisches Kernrohr aufgewickelt sind, daß die innere Teilkapazität zum Kernrohr sowie die innere zur äußeren Teilkapazität durch eine oder mehrere Lagen Isoliermaterials getrennt sind, und daß das ferromagnetische Längsglied innerhalb des Kernrohrs angeordnet ist.

Dabei weist der Kondensatorwickel Stirnkontaktschichten auf, die auf der einen Stirnseite den gemeinsamen Pol der kapazitiven Querglieder bildet.

Vorteilhaft ist es, wenn das metallische Kernrohr als elektrische Verbindung zwischen innerer Teilkapazität und Durchführungsleiter dient.

Weiterhin ist es zweckmäßig, wenn die Enden des Isoliermaterials auf der Stirnseite, die dem gemeinsamen Pol gegenüberliegt über die Stirnkontaktschichten überstehen, um Kriechströme zwischen den Teilkapazitäten zu verhindern.

Die Erfindung wird anhand der folgenden Ausführungsbeispiele erläutert.

In der dazugehörenden Zeichnung zeigen:
Fig.1 ein koaxiales Durchführungsfilter und
Fig.2 ein Schaltbild des koaxialen Durchführungsfilters.

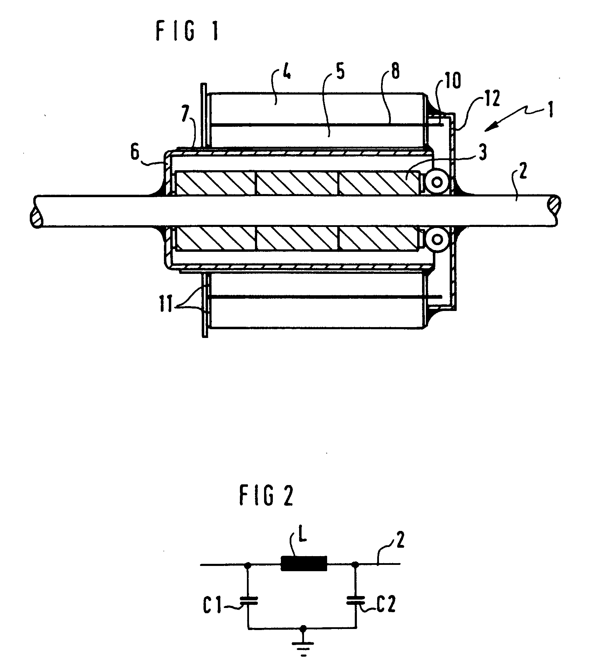

In der Fig.1 ist ein koaxiales Durchführungsfilter 1 dargestellt, bei dem auf einen Durchführungsleiter 2 ein ferromagnetisches Längsglied 3 angeordnet ist. Die als kapazitive Querglieder dienenden Kondensatoren sind in Form eines einzigen Wickels mit zwei Teilkapazitäten 4,5 ausgeführt, die übereinander auf ein metallisches Kernrohr 6 gewickelt sind. Die innere Teilkapazität 5 ist zum Kernrohr 6 durch eine oder mehrere Lagen aufgewickelten Isoliermaterials 7 (Isolierpapier oder Kunststoffolie) getrennt. Zwischen äußerer 4 und innerer Teilkapazität 5 ist ebenfalls

Isoliermaterial 8 verwickelt, dessen Enden 10 über die eine Stirnseite des Kondensators definiert überstehen, so daß Kriechströme zwischen den Teilkapazitäten 4,5 vermieden werden.

Der gemeinsame Pol der kapazitiven Querglieder in der π-Schaltung wird in idealer Form durch die eine Stirnseite 11 des Trennlagenwickels verkörpert.

Das metallische Kernrohr 6 wird zur Kontaktierung zwischen innerer Teilkapazität 5 und dem Durchführungsleiter 2 verwendet, während die äußere Teilkapazität 4 über eine metallische Kappe 12 auf der gegenüberliegenden Stirnseite mit dem Durchführungsleiter verbunden ist.

Das ferromagnetische Längsglied 3 ist innerhalb des Kernrohres 6 angeordnet.

In der Fig.2 ist das Schaltbild des in Fig.1 dargestellten koaxialen Durchführungsfilters dargestellt, wobei die als kapazitiven Querglieder dienenden Teilkapazitäten 4,5 mit C1 und C2 und das ferromagnetische Längsglied 3 mit L bezeichnet sind.

Der Gegenstand der Erfindung zeichnet sich dadurch aus, daß nur noch ein einziger Kondensatorwickel benötigt wird, was bei der Verarbeitung (Wickeln, Transportieren, Zwischenlagern, Kontaktieren durch Flammspritzen, Reinigen, Ausbrennen und Montieren) große Vorteile hat. Ferner entfallen gegenüber den bisherigen koaxialen Durchführungsfiltern ein Kernrohr sowie eine Lötscheibe durch Kontaktierung innere Teilkapazität/Durchführungsleiter über das metallische Kernrohr. Weiterhin sind ein optimal konzentrischer Aufbau und lediglich eine Kontaktstelle zwischen Einbau und Gehäuse erwähnenswert.

## Patentansprüche

1. Koaxiales Durchführungsfilter,
- mit einer π-Schaltung mit zwei kapazitiven Quergliedern (C1,C2) und einem ferromagntischen Längsglied (L,3)
- bei dem die kapazitiven Querglieder als konzentrisch über einem Durchführungsleiter (2) angeordnete und auf ein metallisches Kernrohr (6) aufgewickelte Wickelkondensatoren ausgebildet sind, die in einem Kondensatorwickel mit zwei Teilkapazitäten übereinander angeordnet eine erste innere Teilkapazität (5) und eine zweite äußere Teilkapazität (4) umfassen,
- bei dem eine Stirnkontaktschicht (11) am Kondensatorwikkel vorgesehen ist, die den gemeinsamen Pol für die die kapazitiven Querglieder (C1,C2) bildenden Teilkapazitäten darstellt,
- bei dem jeweils zwischen Kernrohr (6) und innerer Teilkapazität (5) sowie zwischen innerer und äußerer Teilkapazität (4) eine oder mehrere Lagen Isoliermaterial (7,8) angeordnet sind,
- bei dem das ferromagnetische Längsglied (L) auf dem Durchführungsleiter (2) innerhalb des Kernrohrs angeordnet ist.

2. Koaxiales Durchführungsfilter nach Anspruch 1,
bei dem das metallische Kernrohr (6) als elektrische Verbindung zwischen innerer Teilkapazität (5) und Durchführungsleiter (2) dient.

3. Koaxiales Durchführungsfilter nach Anspruch 1 oder 2,
bei dem die Enden (10) des Isoliermaterials (8) auf der dem gemeinsamen Pol (11) gegenüberliegenden Stirnseite des Kondensatorwickels über dort befindliche Stirnkontaktschichten überstehen, um Kriechströme zwischen den Teilkapazitäten (C1,C2) zu verhindern.

## Claims

1. Coaxial feedthrough filter.
- having a π circuit with two capacitive parallel-path elements (C1, C2) and a ferromagnetic series-path element (L,3),
- in which the capacitive parallel-path elements are designed as wound capacitors, which are arranged concentrically onto a feedthrough conductor (2), are wound onto a metallic core tube (6) and which comprise, in a capacitor winding with two component capacitors arranged one above the other, a first inner component capacitor (5) and a second outer component capacitor (4),
- in the case of which there is provided on the capacitor winding an end-face contact layer (11) which constitutes the common pole for the component capacitors forming the capacitive parallel-path elements (C1, C2),
- in the case of which one or more layers of insulating material (7,8) are arranged in each case between the core tube (6) and inner component capacitor (5) and between the inner and outer component capacitors (4), and
- in the case of which the ferromagnetic series-path element (L) is arranged on the feedthrough conductor (2) inside the core tube.

2. Coaxial feedthrough filter according to Claim 1, in the case of which the metallic core tube (6) serves as electric connection between the inner component capacitor (5) and feedthrough conductor (2).

3. Coaxial feedthrough filter according to Claim 1 or 2, in the case of which the ends (10) of the insulating material (8) on the end face, opposite the common pole (11), of the capacitor winding project over end-face contact layers located there, in order to prevent leakage currents between the component capacitors (C1,C2).

## Revendications

1. Filtre de traversée coaxial,
- comprenant un circuit π ayant deux éléments (C1, C2) transversaux capacitifs et un élément (L, 3) longitudinal ferromagnétique
- dans lequel les éléments transversaux capacitifs sont constitués de condensateurs bobinés qui sont disposés sur un conducteur (2) de traversée et enroulés sur un noyau (6) tubulaire métallique et qui comprennent dans un bobinage de condensateur ayant deux sous-capacités superposées, une première sous-capacité (5) intérieure et une deuxième sous-capacité (4) extérieure,
- dans lequel il est prévu sur le bobinage de condensateur une couche (11) de contact frontale, qui représente le pôle commun pour les sous-capacités formant les éléments (C1, C2) transversaux capacitifs,
- dans lequel respectivement entre le noyau (6) tubulaire et la sous-capacité (6) intérieure ainsi qu'entre les sous-capacités (4) intérieure et extérieure, il est prévu une ou plusieurs couches de matière (7, 8) isolante,
- dans lequel l'élément (L) longitudinal ferromagnétique est disposé sur le conducteur (2) de traversée à l'intérieur du noyau tubulaire.

2. Filtre de traversée coaxial suivant la revendication 1,
dans lequel le noyau (6) tubulaire métallique sert de liaison électrique entre la sous-capacité (5) intérieure et le conducteur (2) de traversée.

3. Filtre de traversée suivant la revendication 1 ou 2,
dans lequel les extrémités (10) du matériau isolant dépassent, du côté frontal du bobinage du condensateur qui est opposé au pôle (11) commun, des couches de contact frontales qui s'y trouvent, pour empêcher du courant de fuite entre les sous-capacités (C1, C2).
